(19) Europäisches Patentamt / European Patent Office / Office européen des brevets

(11) **EP 3 715 879 B1**

(12) **EUROPEAN PATENT SPECIFICATION**

(45) Date of publication and mention
of the grant of the patent:
**10.03.2021 Bulletin 2021/10**

(51) Int Cl.:
***G01R 31/50*** *(2020.01)*        ***G01R 31/42*** *(2006.01)*
***G01R 31/64*** *(2020.01)*

(21) Application number: **19305380.8**

(22) Date of filing: **26.03.2019**

(54) **NON-INTRUSIVE ESR/C ESTIMATION METHOD FOR DC BUS CAPACITOR AGEING DETECTION IN POWER CONVERTERS**

NICHT-INTRUSIVES ESR/C-SCHÄTZVERFAHREN ZUR ERKENNUNG DER ALTERUNG EINES DC-BUSKONDENSATORS IN LEISTUNGSUMRICHTERN

PROCÉDÉ D'ESTIMATION D'ESR/C NON INTRUSIF POUR LA DÉTECTION DU VIEILLISSEMENT DE CONDENSATEUR DE BUS CC DANS DES CONVERTISSEURS DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.09.2020 Bulletin 2020/40**

(73) Proprietors:
• **Mitsubishi Electric R&D Centre Europe B.V.
1119 NS Schiphol Rijk Amsterdam (NL)**
Designated Contracting States:
**FR**
• **Mitsubishi Electric Corporation
Tokyo 100-8310 (JP)**
Designated Contracting States:
**AL AT BE BG CH CY CZ DE DK EE ES FI GB GR HR HU IE IS IT LI LT LU LV MC MK MT NL NO PL PT RO RS SE SI SK SM TR**

(72) Inventors:
• **FOUBE, Laurent
35708 RENNES Cédex 7 (FR)**
• **MOLLOV, Stefan
35708 RENNES Cédex 7 (FR)**

(74) Representative: **Plasseraud IP
66, rue de la Chaussée d'Antin
75440 Paris Cedex 09 (FR)**

(56) References cited:
**US-A1- 2005 169 018        US-A1- 2009 072 839**

• **XING-SI PU ET AL: "Fault Diagnosis of DC-Link Capacitors in Three-Phase AC/DC PWM Converters by Online Estimation of Equivalent Series Resistance", IEEE TRANSACTIONS ON INDUSTRIAL ELECTRONICS, IEEE SERVICE CENTER, PISCATAWAY, NJ, USA, vol. 60, no. 9, 1 September 2013 (2013-09-01), pages 4118-4127, XP011507080, ISSN: 0278-0046, DOI: 10.1109/TIE.2012.2218561**

**Description**

**Field of the invention**

The present invention concerns non-intrusive monitoring of parameters of a power converter and is applicable in particular to a three-phase inverter with a diode front-end rectifier possibly with a DC reactor and a DC link capacitor bank where a digital signal processor controls commutation of switches through PWM modulation.

The present invention seeks to provide an online non-intrusive estimation of damage sensitive electrical parameters of the DC Link capacitor bank, such parameters being determined based on the monitoring of HF parts of voltages and currents in the converter circuit.

In addition the present invention aims to provide estimation of parameters such as the equivalent series resistance (ESR) and capacitance (C) during the life of the power converter in order to provide ageing detection of the DC-link capacitor bank. In the present invention, "Non-intrusive" means that no additional current sensing means is added to determine DC-link current within capacitor(s), which is calculated using only information provided by the available current sensing means in connection with the DSP and switching states control of the switching devices of the converter.

In a converter life, as the capacitor bank is ageing, at least one of the ageing indicators will evolve above some limit value and will be used to determine when maintenance is required. For instance in an electrolytic capacitor, the equivalent series resistance (ESR) will typically strongly increase and capacitance (C) will decrease with degradation due to dry out of electrolyte. Which ageing indicator comes first (either strong increase of ESR and/or significant decrease of capacitance) depends on the capacitor type and operating conditions. For film capacitors, a good ageing indicator would be the detection of decrease of C. The ability to monitor voltage and current parameters and additionally calculate an evaluation of ESR and C parameters through the process of the invention enables thus to assess state of health of capacitor, independently of their type.

**Background**

Different techniques are described within published literature to perform on-line monitoring (i.e. while the capacitors are physically connected within power converter) but this usually requires a particular operating mode to perform estimation. For instance, some disturbances are created by injecting an AC current on the motor side of a converter to create voltage ripple across capacitor(s) that can be analyzed. This in turn creates some vibrations and torque ripple as a side effect. In other monitoring processes, some particular operating mode is required to ensure that capacitor's current can be calculated, for instance the motor must be in regenerative mode (i.e. decelerating and acting as a generator) to ensure that DC-bus is driven only by the output bridge while input front-end is blocked. Such operating mode is neither necessarily possible nor desirable during normal operation of the system.

Finally some other methods require the use of an additional sensor to measure the capacitor current, which again is not always possible or desirable (due to the cost of the sensor, to the added impedance...).

Document US 2009/072839 A1 describes an apparatus and method to detect failure of an electrolytic capacitor that smoothes a DC voltage in an inverter circuit. The apparatus includes a voltage meter, a current sensing unit, and a controller. The voltage meter measures a DC voltage of an inverter when the motor is not in operation. The current sensing unit measures a phase current of the motor when the motor is not in operation. The controller estimates an ESR value of the smoothing electrolytic capacitor from the DC voltage of the inverter and the motor phase current to detect failure of the smoothing electrolytic capacitor. US2005/169018 teaches similar art.

**Summary of the invention**

The present invention proposes to alleviate the previous problems by estimating the high frequency (HF) current part of the capacitor current contributed by the inverter part while the unknown low frequency part (LF) generated by the front-end can be ignored. This is done through calculating the inverter current using available output phase currents sampled at particular positions synchronized with switching of the inverter during normal operation of the power converter without creating any additional disturbance.

In order to achieve such measurements, the present invention proposes a method of performing monitoring of parameters of a DC bus capacitor bank according to claim 1. The invention also provides a power converter system according to claim 15.

The invention provides a simple way to measure parameters of the converter in normal operation situations.

It should be noted that the number of current sensing means to measure phase currents depends on the number of legs in the output stage. In the case the output stage comprises n legs where a leg is an upper and a lower switch connected in series, measurement of the phase currents on the outputs of n-1 legs and switching state of the output stage permit to calculate the input current of the output stage. A single phase inverter which has two legs will require one phase current measurement; a three-phase inverter which has three legs will require two phase currents measurements.

According to this embodiment, the parameters of the capacitor bank can be calculated at any time during the operation of the power converter and do not need specific conditions such as regeneration condition or injection of mechanical or external electrical ripple which provides an easily implemented system.

In a specific embodiment, said sampling locations are defined to provide a middle of switching state position as said first location and a near end of switching state position as said second location.

This allows a more convenient calculation process.

In case a parameter under monitoring is the equivalent series resistance ESR of the capacitor bank, the method comprising further calculating an approximated ESR through:

$$\text{ESR} = \frac{\Delta \text{Vcap\_HF}}{\Delta \text{Icap\_HF}}$$

In such case, the approximated ESR is easily calculated during a switching cycle and more precisely at the transition between two consecutive switching states during a switching cycle.

The method may then comprise estimating an ageing state of said capacitor bank by comparing the reconstructed ESR value with a limit value where said value may be function of temperature or capacitor type for instance.

The limit value may be a percentage of an initial value or any given limit.

In case a parameter is the capacitance C of the capacitor bank, in a first embodiment where Idc has a HF component, the method comprises further calculating said capacitance through measurements within a first vector followed by a second vector where one of said first and second vector is an active vector and the other of said first and second vector is a null vector and comprising:

- calculating the variation $\Delta$Vcap(1) of voltage ripple over a duration $\Delta$T1 in said null vector and preceding or following said active vector;
- calculating the variation $\Delta$Vcap(2) of voltage ripple over a duration $\Delta$T2 in said active vector using DC bus voltage measurements made at a middle position and a near end position in said active vector and extrapolating the voltage value at the beginning of said active vector;
- calculating I1avg=average HF capacitor current during said active vector;
- calculating

$$\Delta \text{Vc}(2) = \Delta \text{Vcap}(2) - \text{ESR} \cdot (\text{I1}(t4) - \text{I1}(t2)) \text{ ;}$$

- calculating an approximated capacitance C as being

$$C = \text{Abs}\left(\frac{\text{I1avg}}{\frac{\Delta \text{Vc}(1)}{\Delta \text{T1}} - \frac{\Delta \text{Vc}(2)}{\Delta \text{T2}}}\right) \text{ with } \Delta \text{Vc}(1) = \Delta \text{Vcap}(1).$$

The near end position is the end of the vector from which a sampling margin and dead time duration are subtracted in order to provide a stable measurement.

In case a parameter to be calculated is the capacitance C of the capacitor bank and the inverter current Iinv is considered constant within a switching state, the method comprising further calculating an approximated capacitance through the formula:

$$C = \frac{\text{I1avg}}{\frac{\Delta \text{V'cap}(1)}{\Delta \text{T'1}} - \frac{\Delta \text{V'cap}(2)}{\Delta \text{T'2}}}$$

Where $\Delta$T'2 corresponds to a second half period duration of an active vector reduced by the sampling margin and dead time duration and where $\Delta$V'cap(1) corresponds to the variation of voltage ripple over a duration $\Delta$T'1 in a null vector and preceding or following said active vector, $\Delta$V'cap(2) corresponds to the difference between the two measured values at an end position and at a middle position in said active vector, and where I1avg corresponds to the current value of Iinv at the middle position of said active vector.

This provides a simplified calculation for C.

The method may further comprise estimating an ageing state of said capacitor bank by comparing the calculated capacitance value and/or the calculated equivalent series resistance value with limit values function of capacitor temperature.

This provides a satisfactory monitoring of the capacitor bank during life of the power converter. According to the situation, the limit values may be percentages, coefficients or absolute values, said limit value being expressed either as a maximum variation with respect to initial value (increase , or decrease expressed in %) or directly as a limit value such as a minimum value of the capacitance Cmin and/or a maximum vale of resistance ESRmax expressed in the parameter unit.

Reconstructing the voltage ripple may comprise removing the DC component of said voltage for delivering a ripple containing only the LF+HF contents to provide better accuracy of the measurements.

In case the front end delivers DC+LF+HF content, the method may comprise measurement or calculation of the HF part of the front end current in order to subtract such content from the estimated capacitor current.

In order to reduce the number of operations of a DSP or controller, sampling of the phases currents is done in at least one active switching state (or active vector) where energy is exchanged between the DC bus capacitor and a load of the inverter for providing calculation of HF capacitor current ripple in said active switching state.

In case where the converter is a three-phase inverter system having current sensing means on at least two phases, said current sampling is done on said at least two phases of the inverter.

This allows using already existing current sensing means. More generally the number of sensors used corresponds to the minimum number of sensors needed to calculate the inverter current.

In case the front end delivers DC+LF+HF content, the method comprising measurement or calculation of the HF part of the front end current in order to subtract such content from the estimated capacitor current.

In case where the capacitor current does not comprise unknown LF component, the method may comprise a measurement of the capacitor voltage variation $\Delta V'cap(2)$ of a duration $\Delta T'2$ within a single active vector switching state, a measurement of the mean output stage current in said switching state and a calculation of C according to the formula:

$$C = Abs(\frac{I1avg}{\frac{\Delta V'cap(2)}{\Delta T'2}})$$

The measurement is preferably done in a state where the front end delivers no current.

This provides a simplification of the calculation of C and less load on the calculation unit.

In such case, estimation of capacitance may be obtained by retaining and averaging only the largest C estimations.

This permits to increase the measurement accuracy and to avoid to consider the situations where the frond ends conducts current or not as in a diode rectifier circuit where discontinuous conduction occurs.

It might also be possible to determine the regions of non-conduction of rectifier current by considering the variability of successive estimations of C over given period e.g. using short term statistics over consecutive measurements as small variations of C corresponds to periods of non-conduction of rectifier, where measured C tends to real capacitance.

A monitoring process using the method of the invention may comprise a self-calibration and memorization process at the beginning of operation of the converter for providing and memorizing initial values for the monitoring and calculation of limit values based on said initial values using the method of the invention through the life of the power converter.

Such a monitoring process provides an estimation of the ageing of the capacitor bank from the beginning of the operation of the power converter and the initial values used for the monitoring.

The invention concerns further a power converter system configured for enabling the method of the invention for monitoring of parameters of a DC bus capacitor bank, said converter comprising:

- a front-end feeding power to a DC bus;
- a capacitor bank;
- an output stage and PWM control of gates of switches of the output stage, said output stage providing one or more output phases;
- a voltage sensing means on the DC bus of the capacitor bank, said voltage sensing means comprising a conditioning circuit providing high pass filtering and scaling of a HF component of the DC bus;
- current sensing means on phases of the output stage of the converter allowing calculation of the output stage input current;
- a calculation unit such as in a CPU or DSP comprising analog to digital converters and configured to execute, in addition of standard control of the output stage of the converter, calculations of sampling positions, acquisitions of sampled values of voltage and current at said sampling positions and calculation of parameters and limits based on said acquisitions;

- read only memory and read/write memory for executing said method, read/write permanent memory for storing initial values and limit values and read/write memory for processing calculations.

The method of the invention limits the need of additional hardware which is cost efficient.

In the calculations, the limit values may be a maximum allowed variation at a given temperature, absolute values or percentages of initial value depending of the software.

## Brief description of the drawings

A detailed description of exemplary embodiments of the invention will be discussed hereunder in reference to the attached drawings where:

Figure 1 is a schematic representation of a three-phase inverter according to the invention;
Figure 2 is an example of timing diagram of switching of gates on an exemplary switching cycle of a SVPWM modulation as well as an illustration of sampling positions;
Figure 3 shows an example of commutation with transient signals;
Figures 4A and 4B provide an illustration of inverter current and capacitor voltage ripple shapes during an exemplary SVPWM switching cycle of a three-phase converter, for ESR calculation;
Figure 5 provides a schematic representation of signals and of a first realization mode of measurement method, for capacitance calculation;
Figure 6 provides a schematic representation of signals and of a second realization mode of measurement method, for capacitance calculation;
Figure 7 is a schematic representation of a single phase inverter according to an embodiment of the invention;
Figure 8 is a schematic representation of a three-phase inverter with intermediate PFC stage according to an embodiment of the invention.

## Detailed description of embodiments of the invention

The present invention concerns monitoring of ageing of a DC link capacitor or capacitor bank in a power converter without adding current sensing means in the capacitor branch.

In a power converter such as an inverter, the capacitor or capacitor bank that filters the rectifier voltage is subject to ageing and loss of its characteristics over time.

Usually such capacitor bank is considered as aged when its equivalent series resistance ESR is twice its initial value and/or its capacitance C has lost 20% of its initial value considered at a given stabilized temperature.

To measure ageing of the capacitor or capacitor bank, a direct measurement of the capacitor current is usually not available and standard power converters only have sensors needed for the operation of the PWM control such as current sensing means on converter phase(s) and a voltage sensing means on the DC front end.

The method of the invention operates without disturbing the normal operation of the power converter. It requires minimal additional hardware such as voltage ripple conditioning and is mostly implemented by the controller or DSP in charge of power converter's control which is configured to have memory, registers and software adapted for the necessary calculations to provide ageing determination of the capacitor bank.

The method is illustrated thereafter for a three-phase inverter system with a passive diode front-end rectifier, completed possibly with DC reactor and/or AC reactors.

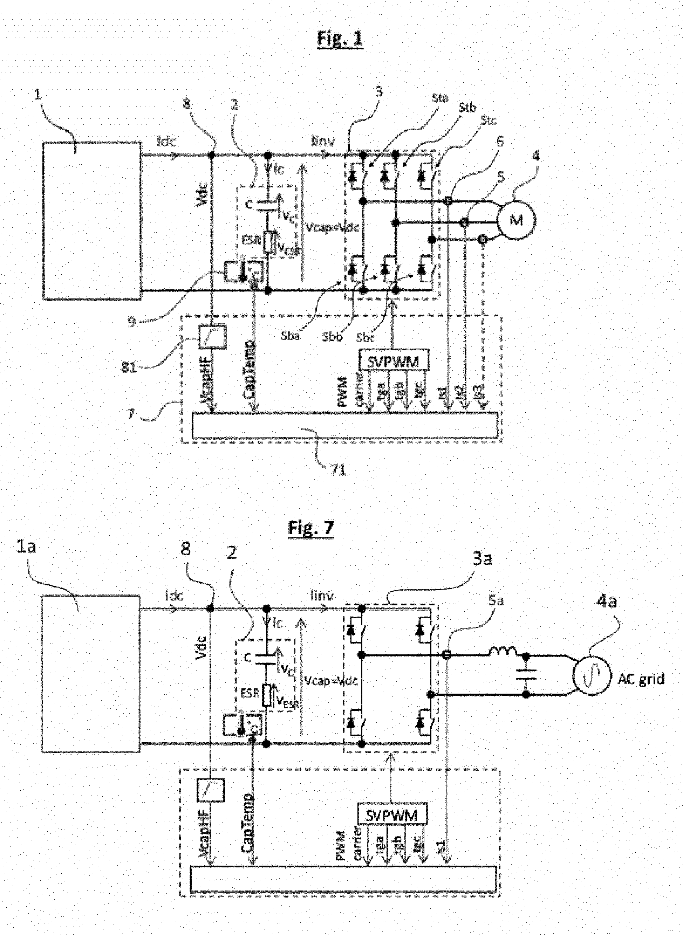

Figure 1 is a schematic representation of a three-phase inverter according to an embodiment of the invention. The power converter comprises a DC front end 1 such as a rectifier or other DC source, a capacitor bank 2, an output stage 3, a motor 4, current sensors 5, 6 on two of the motor phases, a command module 7 with a digital signal processor (DSP) or microcontroller, voltage sensing means 8, 81 to measure the DC-bus voltage and a conditioning circuit 81 that extracts and scales the HF ripple of the DC bus voltage. The DSP executes the Motor control algorithms such as speed control loop, V/F control etc) and the space vector PWM (SVPWM) algorithm finally determines the timing of the gates commands.

In figure 1 the output stage is a three-phase inverter but the output stage may be a converter of another type such as a single phase inverter described in figure 7 and discussed hereunder. In the present description the PWM switching strategy is considered to be SVPWM and in such case an "active vector" corresponds to a configuration of switches leading to power exchange between the DC bus and the load (motor): Ic<>0, with Ic being the capacitor current.

Alternatively during a "0-voltage vector" the inverter has no effect on current within the DC bus capacitor(s).

In figure 1 the output stage has three legs, leg Sta, Sba, leg Stb, Sbb, and leg Stc, Sbc which provide a three phase output. At least two current sensing means 5, 6 are present to measure the currents on two phases. The current on the third phase and in consequence the input current Iinv of the output stage (an inverter in the present case) may be calculated with knowledge of two phase currents only.

In case of a converter providing a single phase output as in figure 7, only one current sensing means on the output phase of one leg is needed to calculate the output stage input current.

All measurements or signal lines are regrouped on a monitoring unit 71 of the DSP or controller treating analog to digital and digital entries and providing the necessary calculations for the process of the invention.

Such monitoring unit is mainly provided by software implemented in the DSP.

In the power converter, currents are Idc: front-end current; Ic: capacitor current; Iinv: output stage input current.

In the capacitor bank, the measurable voltage is Vcap which is the sum of Vc, voltage of ideal capacitor, and Vesr, voltage in the equivalent series resistance of the capacitor, which are internal capacitor voltages that cannot be directly differentiated.

The DSP or microcontroller comprises a health monitoring system which receives several information such as signals and parameters. Such signals are:

A signal representative of the DC voltage ripple VcapHF, the temperature of the capacitor bank CapTemp, the DSP PWM carrier, the leg switching times signals tga, tgb, tgc, the phase current sensing means outputs Is1, Is2 and optionally Is3 if three sensors are present. The bottom command signals of the bottom gates (Sba, Sbb, Sbc) which are in correspondence with the command signals of the top gates do not need to be provided to the health monitoring system.

With respect to tga, tgb, tgc, the crossings of such values with the carrier give the time of activation and deactivation of a particular top gate. The leg switching times tga, tgb and tgc are used to control the activation and deactivation of the top switches Sta, Stb, Stc and bottom switches Sba, Sbb, Sbc.

As known in the art, the PWM carrier is an internal signal of the DSP that provides a basis for the switching scheme and SVPWM timing.

The basis of the calculations of the present invention uses the evaluation of HF ripple created by harmonics of the switching frequency of the converter. In particular the $2^{nd}$ harmonic of the switching frequency, which is the major harmonic for SVPWM modulation, is used, such switching frequency being commonly in the range 2,5kHz ... 30 kHz and in typical applications around 10 KHz.

The VcapHF signal is extracted from the DC bus voltage VDC which is equal to Vcap. In VcapHF, the DC component is suppressed and low frequency ripple of VDC possibly strongly attenuated. The low frequency ripple is generated by the front end stage, and is typically a 300 Hz ripple in the case of a 50 Hz three phase rectifier. The suppression of DC component is performed by the conditioning circuit 81 which also scales the HF ripple in correspondence with the range of the analog to digital converter (ADC) in the DSP.

With respect to ESR measurement, a high pass filter could be added to suppress low frequency ripple. However this could interfere with the HF ripple measurement and be detrimental for C measurement.

Since no current sensing means is used to measure the capacitor current, this current is estimated by calculation. The HF part of the capacitor current is accurately calculated using available phase current sensing means and inverter switching information considering that the inverter switching is the only source of HF contents.

It should be noted that in case a current sensing means is already available on the DC bus, a more accurate estimation of the capacitor current could be possible.

As it will be explained hereunder, the estimation of C and ESR are based on analysis of signals in the time domain by sampling signals at particular positions. A nonconventional sampling scheme as well as extrapolation is used to reconstitute a very accurate HF current with its ripple information corresponding to linear current variation during each switching state.

The reconstructed HF current as well as the measured voltage ripple are then jointly analyzed to allow estimation of the equivalent series resistance and capacitance of the capacitor bank.

With the proposed method, no LF component is required to estimate C. This also constitutes an advantage when no LF is generated by the front-end, in case of a DC source for instance.

The estimation of parameters can possibly be made quite frequently allowing numerous estimations, and thus improving the accuracy of estimations.

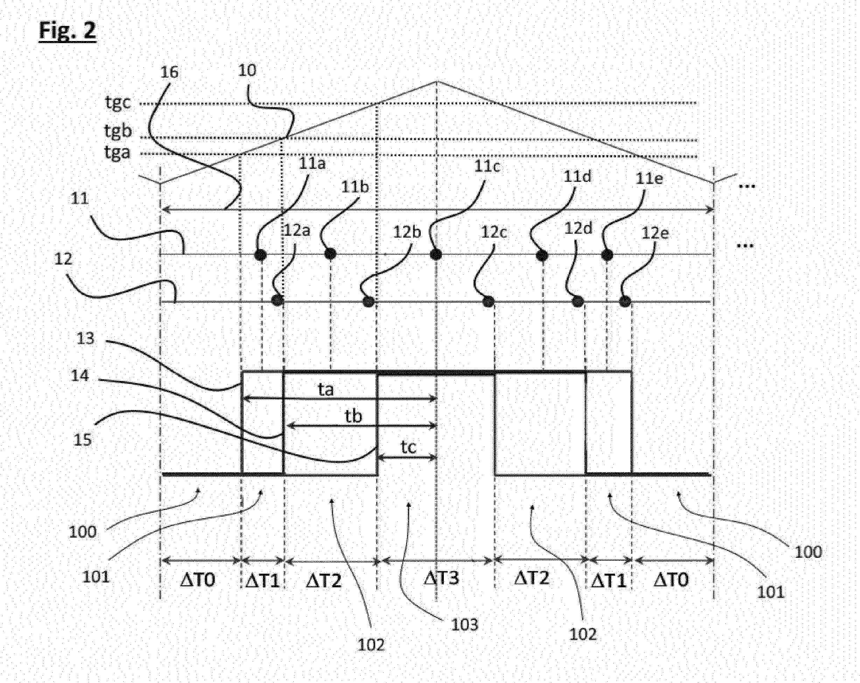

Figure 2 describes schematically an example of SVPWM switching cycle showing the command of the upper gates of the inverter stage as well as illustration of sampling positions.

In figure 2, the active vectors are labeled 101 and 102, and have a respective duration of $\Delta T1$ and $\Delta T2$ and the 0-voltage vectors are labeled 100 and 103.

Figure 2 represents the diagram of signals in an exemplary switching interval where a gate signal of a switch Sta (e.g. top switch Sta of figure 1 of a first leg A) is on (i.e. activated) according to curve 13 for a duration of 2*ta, where a gate signal of a switch Stb (e.g. top switch Stb of figure 1 of a second leg B) is on according to curve 14 for a duration of 2*tb and where a a gate signal of a switch Stc (e.g. top switch Stc of figure 1 of a third leg C) is on according to curve 15 for a duration of 2*tc.

The gate signals timings are typically determined by a SVPWM algorithm every switching cycle 16 based on the PWM carrier 10 and trigger levels tga, tgb, tgc determined for the gates according to the different sectors of the SVPWM inside the DSP. In this regard, it should be noted that the example of figure 2 is an example of à SVPWM switching interval within a sector where ta>tb>tc and that other configurations are present in the cycle defining the output phase voltage as known in the art.

The sampling positions 11a, 11b, 11c, 11d, 11e and 12a, 12b, 12c, 12d, 12e indicate where some signals can be sampled in order to measure the phase currents and voltage ripple. Positions 12a, 12b, 12c, 12d, 12e correspond to ends of commutation states (vectors101, 102, 103, 102, 101) represented on line 12.

Positions 11a, 11b, 11c, 11d, 11e correspond to sampling position during the switching states. It should be noted that the durations of ON state of the gates can be in any order depending on desired output voltages or currents.

The different switching positions of gates within a switching cycle must be determined to allow calculation of the sampling positions in the different intervals or switching states. Parameters tga, tgb, tgc in combination with the carrier 10 allow determining the durations of the different switching states (vectors labeled 100 to 103 on figure 2) and the sampling positions of the phases currents and voltage ripple. The calculation is based on simple arithmetic and performed only once per switching cycle. For instance in the presented example, the sampling position 11a in middle of first active vector 101 is $\Delta T0 + \dfrac{\Delta T1}{2}$, while the sampling position 12a at end of this period may be:

$\Delta T0 + \Delta T1$ - sampling_margin, with sampling_margin being the maximum time it takes to the ADC to sample the signal to acquire (1µs for instance depending on ADC).

The calculation of the different positions is specific to the modulation method employed and can easily be adapted for instance to sinusoidal PWM modulation (in that case tga, tgb, tgc are sinusoidal modulation signals). The question is first determining the dates of switching of the gates within the switching cycle to determine the different durations. The location of sampling points is derived as a second step as explained above.

The ESR parameter is estimated here by using instantaneous values of capacitor voltage ripple and current ripple, at the transitions between different switching configurations. Each switching configuration, or switching state, corresponds to a given state of the different output switches (not considering the short dead times between two states). Each time a transition occurs between two configurations, a different capacitor current is drawn leading to small discontinuities of capacitor voltage due to its interval ESR. This can be understood according to the formula of capacitor voltage

$$Vcap=Vc+Vesr= \frac{1}{C}\int_{t1}^{t2} Icap \cdot dt + ESR \cdot Ieap$$

Indeed, the internal capacitor voltage Vc, not directly measurable between the terminal of the capacitor, is continuous due to the integration of the capacitor current (i.e. do not varies at the transition between two configurations). On the other hand, the resistive term due to ESR varies instantly with the current variation, causing the discontinuity on capacitor voltage Vcap.

The idea to measure ESR at these locations is to determine the variation of voltage and current upon the transition and perform the following computation:

$$ESR = \frac{\Delta Vcap\_HF}{\Delta Icap\_HF}$$

- where ΔVcap_HF is the difference of (HF) capacitor voltage ripple at the beginning of new switching configuration and the value at the end of previous switching configuration and corresponds to the voltage drop in ESR due to current step between two switching states;
- where ΔIcap_HF is the difference of the HF capacitor current at the beginning of new switching configuration and the value at the end of previous switching configuration that is the amplitude of current step upon transition between switching states. It should be noted that Icap_HF can be considered to be -Iinv in case Iinv is the only source of HF. In such case, ΔIinv is typically equal to - ΔIcap_HF.

The HF capacitor current is calculated considering the switching states of the converter and the available current sensing means (phase currents for the considered example).

For better accuracy of acquisition and obvious adaptation to the ADC (Analog to Digital Converter) used to measure voltage, the capacitor voltage is conditioned to extract and scale the ripple of interest which is a HF voltage ripple.

The HF voltage ripple is extracted by filtering the DC bus voltage to remove its DC component.

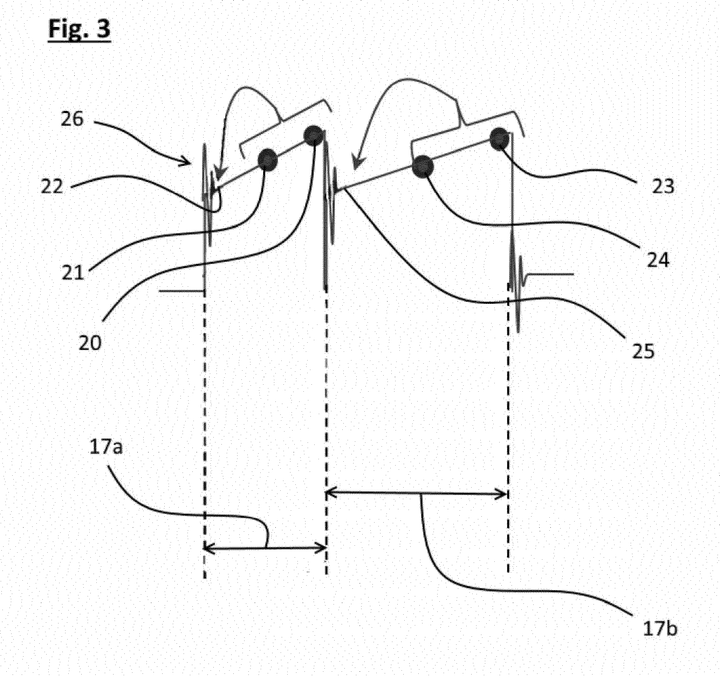

To calculate ΔVcap_HF, which is the difference of the value of voltage ripple at end of a switching state and at the beginning of the following switching state, the capacitor voltage drop should be determined at the position where the current variation due to switching occurs. With a proper trigger, the value at end of switching state can be acquired by ADC. However, due to the presence of parasitic inductance and other non-idealities of switches a transient (high frequency ringing) is present on currents and capacitor voltage following each commutation. Such a transient 26 is represented in figure 3. This prevents a good accuracy acquisition of signals in that region. In addition, to avoid short circuit between two switches of a leg, a small dead time is also present between successive switching states, increasing the time between them.

To tackle this problem, considering that evolution of capacitor current or voltage is pretty linear over the duration of a particular switching configuration, the idea is to determine the beginning value of current or voltage by extrapolation of two other measurements performed later within the switching state (typically at the end and middle of the corresponding switching configuration).

Figure 3 illustrates the principle of recalculating such beginning value in two consecutive switching states or intervals 17a, 17b.

Calculation of a value of the HF capacitor current or voltage 22, 25 at the beginning of said switching states 17a, 17b is done by linear extrapolation of the HF capacitor current or voltage at middle 21, 24 and end 20, 23 positions over said switching states duration.

This is needed because accuracy of a measurement at beginning of switching state cannot be guaranteed due to the transient 26.

The point where it is not possible to accurately sample the signal is estimated by extrapolation of the two other points known in the current switching state according to the general formula $$y(t0) = y0 = y1 + (t0 - t1)\frac{y2 - y1}{t2 - t1}$$

With t0=time at beginning of switching interval; t1=time of first point; t2: time of second point; y1: value of point at t1; y2: value of point at t2.

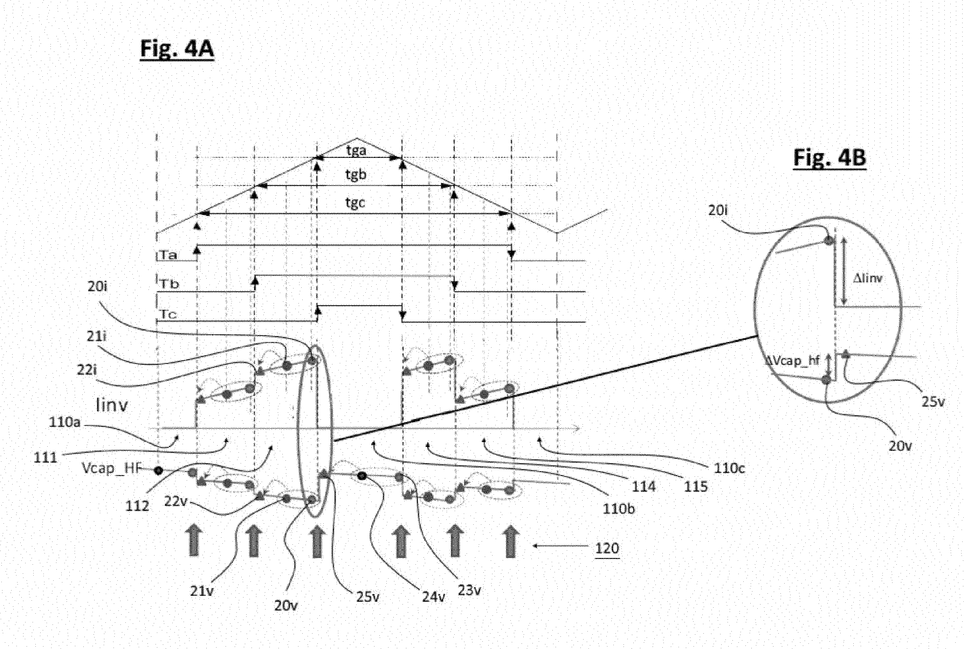

Once determined the value of current ripple and capacitor HF current at beginning of each interval, it becomes possible to calculate the voltage and current variations (respectively $\Delta Vcap\_HF$ and $\Delta Icap\_HF$) upon possibly each transitions and then calculate ESR, as illustrated in Figures 4A and 4B.

In such figure, the switching cycle comprises a first null vector 110a, followed by two active vectors 111, 112, a second null vector 110b, two active vectors 114, 115 and ends with a null vector 110c.

In such cycle, some transitions are more favorable than others for a good accuracy of estimation. For instance, a large $\Delta Iinv$, and in consequence a large $\Delta Icap\_HF$ since the HF contribution of Icap comes from Iinv, will generate a larger $\Delta Vcap\_HF$. On the various possible positions for estimation of ESR, 120 in figure 4A, some switching states comprise positions which require less computation and fewer samples to enable calculation as the one comprising the sampling points 20i and 20v.

It is thus possible to perform estimation only on some selected transitions in order to avoid some useless calculation (and to alleviate the ADC and CPU burden by reducing the number of sampling positions).

For instance, determining Iinv at the end 20i of second active vector 112 in figure 4B provides a direct calculation of $\Delta Icap\_HF$. In such case as Iinv is null in the null vector 110b, $\Delta Icap\_HF$ is equal to Iinv at position 20i. For the voltage ripple Vcap_HF three samples are required: at the end 20v of the second active vector 112, at the middle 24V of the center null vector 110b and at the end 23V of such active vector. The voltage value at the beginning 25v of the center null vector 110b which cannot be measured due to transient signals is determined by extrapolation of the acquired samples 23v, 24v. In such case $\Delta Vcap\_HF$ is equal to the voltage at position 25v minus the voltage at position 20v thus providing for these positions an estimation of ESR with the formula:

$$ESR = \frac{\Delta Vcap\_HF}{\Delta Icap\_HF}$$

The extrapolation method used to estimate the value of a signal after a transition is of general use each time sampling after the transition is not possible. The proposed ESR estimation method may be used also for capacitors in other type of power converters as long as the capacitor current presents abrupt changes and can be calculated.

The principle of estimation of C is to monitor variations of ripple voltage over some time interval due to capacitor current integration. A problem may come from the unknown contribution of Idc. However, provided that the current Idc is of low frequency, it can possibly be considered as constant over at least two consecutive switching configurations which make the estimation possible despite this unknown variable.

The calculation is based on the slope of voltage ripple in two successive switching states that have different capacitor currents. The unknown influence of Idc is almost completely removed by combining equations of voltage variation in two consecutive switching states. It should be noted that the short dead time typically present between these switching states doesn't influence the proposed capacitance calculation method.

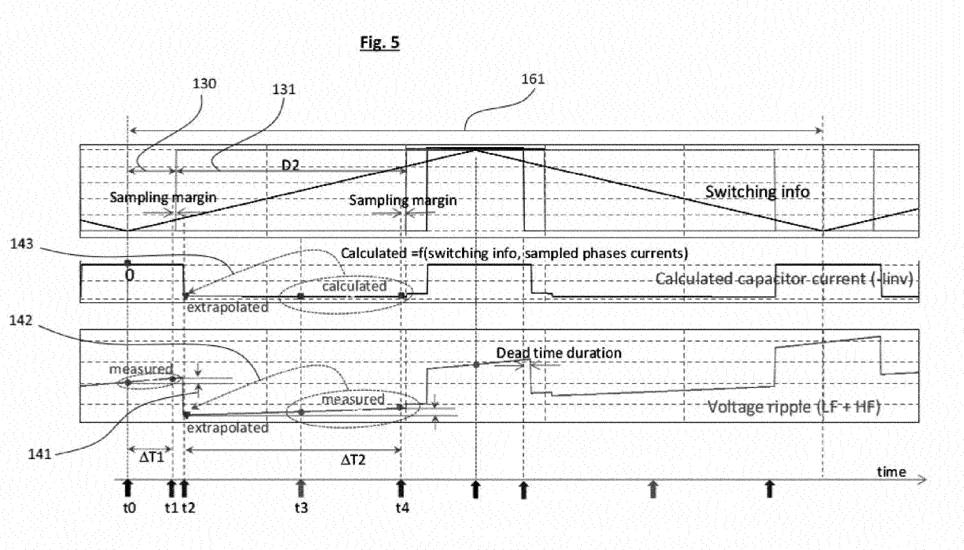

The graph in figure 5 illustrates a first estimation method.

The two consecutive switching states taken into account in the example are respectively a null vector 130 and an active vector 131 following each other of switching cycle 161. A null vector is a configuration with all top switches turned OFF or ON, the bottom switches being in the respective opposite state. In the example, the active vector follows the null vector however the calculation can be done with vectors such as the null vector follows the active vector provided that the absolute value of the calculation is taken in consideration (estimation of C is expected to be positive).

The voltage ripple variation ΔVcap(1) 141 in the null vector 130 is determined using measurements made at beginning of null vector t0 (beginning of switching cycle) and at the end of null vector t1. The inverter current and HF part of capacitor current, are null in this vector and ΔT1=t1-t0 is the duration of the null vector 130 minus the sampling margin. During this vector the capacitor current is the current from the front-end.

The voltage ripple variation ΔVcap(2) 142 in the active vector 131 is determined using measurements made at the middle t3 and at the end t4 of the vector and extrapolation of the initial value at the beginning t2 of the active vector. In that case the phase currents, at least 2 of 3 are also sampled at positions t3 and t4 to enable calculation of the inverter current at these locations. The values of voltage ripple and inverter current after the transition t2 are then obtained by extrapolation of values at positions t3 and t4. ΔT2 is the duration of the active vector 131 from which are subtracted the sampling margin and dead time duration. I1avg is calculated from the phase currents sampled in the middle in active vector. Assuming a slow variation of the input/front-end current, the capacitance can be calculated as:

$$C = Abs\left(\frac{I1avg}{\frac{\Delta Vc(1)}{\Delta T1} - \frac{\Delta Vc(2)}{\Delta T2}}\right)$$

with ΔVc(1) = ΔVcap(1) with no HF current in the null vector and in consequence no voltage drop due to HF current across ESR. In this formula, ΔVc(2) = ΔVcap(2) - ESR · (I1(t4) - I1(t2)) and I1avg=average HF capacitor current during active vector, i.e. typically calculated in the middle of vector as illustrated on figure 5.

The absolute value Abs reflects the possibility of having the active vector following the null vector as in such case the result is negative.

Considering the voltage drop within the ESR of capacitor estimated with the method illustrated above allows enhancing the accuracy of estimation even if the inverter current varies significantly during the active vector, in case of a low output load inductance for instance (PMSM, ...).

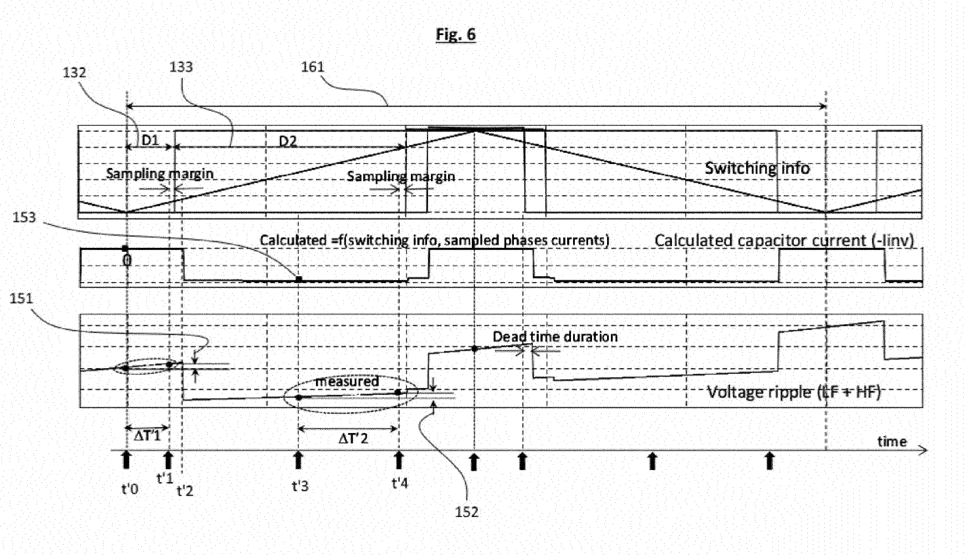

Figure 6 corresponds to the case where the input current of the output stage is almost constant during each active vector. In such case, a simpler method is applicable for estimating C using the formula:

$$C = Abs\left(\frac{I1avg}{\frac{\Delta V'cap(1)}{\Delta T'1} - \frac{\Delta V'cap(2)}{\Delta T'2}}\right)$$

ΔT'2 corresponds here to the second half of the active vector 133 reduced by the sampling margin and dead time duration. In such case, there is no need to extrapolate voltage and current after the transitions. ΔV'cap(1) 151 corresponds to the differences of the Vcap ripple values at t'1 and t'0, ΔV'cap(2) 152 corresponds to the difference between the two measured values at t'4 and t'3 and I1avg 153 corresponds to the current value of Iinv at t'3. This also alleviates the burden for ADC and CPU as there is no extrapolation and no need to sample phase currents several times per switching cycle.

It should be noted that the accuracy of estimation it is linked to the ability to measure precisely the slopes of voltage ripple in two consecutives switching states. This is of course easier when duration of switching states is not too short. It is also expected that the variation of slopes between, for instance, an active vector and a null vector will be more important if the inverter current is large during the active vector.

These criteria can be used to select the more appropriate switching states to perform C estimation.

As an additional processing stage, some filtering might be applied to successive evaluations of C or ESR to improve its precision and alleviate the influence of noise. This can be done for instance by averaging successive evaluations. Other more complicated filtering methods might be used as well to further improve the accuracy of estimation.

The proposed method to estimate capacitance would also be applicable to other type of power converters as long as the capacitor current can be calculated during some switching state allowing estimation. In particular it is applicable to a single phase inverter.

In the simpler case where there is no unknown LF component in the capacitor current, the measurement of voltage variation (of capacitor ripple) within a single switching state is of course sufficient to determine C:

$$C = Abs\left(\frac{I1avg}{\frac{\Delta V'cap(2)}{\Delta T'2}}\right)$$

This simpler method is applicable in particular in case of discontinuous conduction of front end, i.e. when this latter delivers no current (periodically happens with diode rectifier, with possibly small DC inductor or during operation at light load). The capacitance can be estimated simply by measuring the variation of capacitor voltage within a single active vector (avoiding consecutive measurements in a null and active vector). An accurate estimation of capacitance can be obtained by retaining only the largest C estimations, which are those obtained during non-conduction of font-end.

Considering that no current sensing means on the DC bus is available to measure directly Idc, the discontinuous operation could be detected for instance using a simple current detector (no need for accuracy, just detect that no current flows from rectifier stage).

It might also be possible to determine the regions of non-conduction of rectifier current by considering the variability of successive estimations of C over given period (small variations of C corresponds to periods of non-conduction of rectifier, where measured C tends to real capacitance): using short term statistics over consecutive measurements.

Finally, the estimation method might be applicable also to power converter with other type of front-end (boost PFC for instance, delivering not only DC and low frequency contents) as long as its output current can be determined either by measurement or calculation in order to be taken into account in the calculation of estimated capacitor current.

Typically the determination of ESR and C within a switching cycle can be made with the following sequence of steps:

> i. determination of sampling positions in switching cycle, typically middle and near end of each switching state. this is preferably done during the previous switching cycle along with determination of switching pattern for next switching cycle in updating a descriptor that contains the required sampling locations and information to enable reconstruction of capacitor current;
>
> ii. Acquisition of Vcap_ripple samples at these locations, as well as phase(s) current(s) required for Icap_HF current calculation and storage of these values in a buffer for further processing;
>
> iii. For each switching state within the switching cycle:
>
>> a. calculation of capacitor current at the sampling positions using acquired phase(s) current(s) and switching information enabling reconstruction and storage of the calculated values in a buffer for further processing;
>>
>> b. If the switching state is an active vector and the capacitor current is considered not constant over duration of a switching state:
>>
>>> - Determination of the slope of capacitor current using the two calculated values;
>>>
>>> - Extrapolation of beginning value of capacitor current after the transition using the two calculated values;
>>
>> Otherwise: no need to calculate slope and extrapolate in null vector or if current is constant;
>>
>> c. Determination of the slope of voltage ripple using the two samples;
>>
>> d. Extrapolation of beginning of state, just after transition, value of ripple voltage using the two samples;
>>
>> e. Calculation of the average inverter current within each interval: typically the value of current in middle of switching configuration ;
>
> iv. For each transition between two successive switching states stored in buffer or only for selected transitions of interest:
>
>> a. Determine $\Delta$Vcap_HF and $\Delta$Icap_HF at the transitions between these states considering end value of previous state and beginning value in next state
>>
>> b. Calculate

$$ESR = \frac{\Delta Vcap\_HF}{\Delta Icap\_HF}$$

> v. For each couple of successive switching states stored in buffer or only for selected couple of interest:

a. Calculate C as described above using ESR, Δt1, Δt2, ΔVc1, ΔVc2, and average value of inverter current within the successive switching states.

The successive values of estimated ESR and C can possibly be further filtered to enhance their precision (to alleviate effect of noise, quantification errors, impact of sampling time, imperfect rejection of unknown Idc...). Different methods are usable: LPF, moving averaging filter, Kalman filter, etc.

In addition some optimizations are possible to reduce the processing burden when only a single estimation of ESR or C is required in a switching cycle for instance.

Once the calculations of ESR and C are done, the calculated values are compared to limit values; such limit values being based on initial measured values at known temperatures and a coefficient or an allowed maximum variation. For example the limit value for ESR could be 100% increase of initial ESR and the limit value for C could be 20% decrease of initial C at given temperatures after having reached a thermal equilibrium.

The proposed method involves a number of steps that can be typically handled by software, as additional control tasks added to the standard control of inverter. Some tasks are required to be performed in real time: determination of sampling positions, sampling of signals accordingly. Other tasks may be performed in background loop, at a low priority level when processor is available, to perform signal reconstruction and estimation of ESR and C (and of course periodic DC-bus ageing detection).

The proposed method requires a limited number of information to operate but requires a relatively high number of samples per switching cycle if the estimation of C or ESR is to be carried out several times per switching cycle. In practice this is neither required nor desirable since ESR and C are slow evolving parameters, since not all samples are useful for accurate estimation and since it is preferable to alleviate processor load. Selecting one or two locations in the switching cycle to perform calculation and thus strongly reduce the ADC sampling related overhead is preferable in order to adapt the system to the available processing power / capabilities of available ADC.

Despite the apparent complexity of the employed non-uniform ADC sampling scheme (compared to regular sampling), it can be made quite efficient with following considerations:
Sampling triggers to acquire phase currents in mid vectors and near end of vectors, as well as duration of different vectors are calculated only once per switching interval, as an additional processing of SVPWM modulation.

On the CPU or DSP controlling the power converter, a PWM unit for instance can be used to trigger the acquisitions of phase's currents and voltage ripple at required positions.

By exploiting the capability of some ADCs to store several conversion results in different result registers, it is possible to strongly reduce the interrupt overhead: instead of executing ISR interrupt service routine at every end of conversion, the results are read later in time, i.e. at positions where processing takes place, interrupts can thus occur on a regular basis to simplify software organization and optimize processing time.

Estimation of C or ESR is not necessarily performed at every possible location within the switching cycle thus reducing the required number of samples.

In addition, calculation of instantaneous values of the inverter current (HF part of inverter current is HF capacitor current) at a particular time locations within an active vector can be performed using the state configuration of inverter and values of phase currents:
Ic = Sa*Is1 + Sb*Is2 + Sc*Is3, where Sa, Sb, Sc are the state of upper switches of inverter (0 or 1) and Is1, Is2 and Is3 designate the values of phases currents of respectively phase A to phase C, at the time considered.

With the proposed method to reconstruct current, it becomes possible to reconstruct accurately even the slope of Iinv variation within each switching state.

It should be noted that in case the output inductance of load is relatively high (low HF ripple of phase currents), the phase currents can be considered as pretty constant during a whole switching state and in that case, there is no need to determine the slope of the current within each switching state. A simpler sampling scheme can be used in that case: either one sample (of phase(s) current(s)) per switching state or even (if phase currents do not evolve significantly over a whole switching cycle) using one or two samples per switching cycle. In these cases, only the ripple voltage need to be sampled with described sampling scheme. Also, the estimation of ESR or C cannot be carried out everywhere, typically when a switching state is too short to allow correct sampling in its middle and or just before its end. This happens for instance when space vector (case of SVPWM modulation) goes from one sector to another. The problematic conditions can be avoided by selecting appropriate positions for correct estimation.

The proposed method uses the ripple naturally present in this kind of power converter for estimation of parameters without the need to create any additional disturbances. No particular mode of operation of the power converter is required for operation of the invention. In particular there is no need to operate only when the input front-end does not deliver current to the DC bus, under the assumption that the front-end only creates an unknown but slow evolving (low frequency compared to switching frequency) disturbance of the DC bus voltage.

Figure 7 provides an example of application of the invention in a single phase inverter where Iinv is calculated using the output current of a leg measured with a sensor 5a. In this embodiment the front end 1a may be solar panels or any other DC source.

In this case where the output stage comprises a single phase, the phase current measured at the different locations on such single phase together with the knowledge of the state of the switches permits to calculate the input current of the output stage Iinv.

In figure 1 where a three phase system is described and in case the output stage comprises n legs, measurement of the phase currents on the output of n-1 legs permits to calculate the input current of the output stage Iinv without the need of sensors on all of the phases.

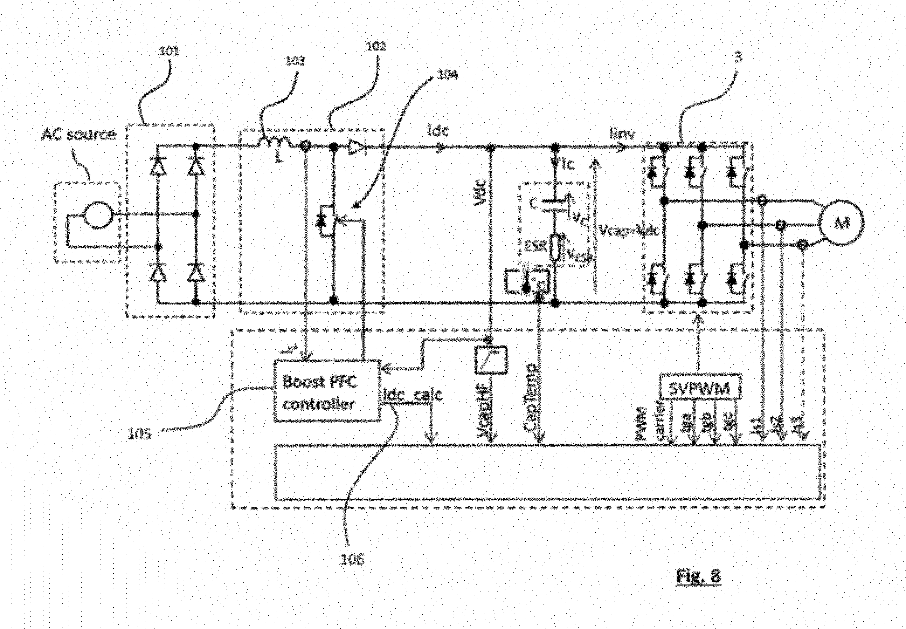

Figure 8 provides an example of application with a power converter having an intermediate PFC stage between the DC-bus and a front end based on rectifiers 101.

Here a boost PFC 102 (power factor correction) is used to control the DC bus voltage while absorbing a sinusoidal current from the grid in order to reduce the level of harmonics currents on the input side.

The output current Idc of that stage contains HF contents which can be measured or calculated (Idc_calc) 106 considering the current $I_L$ of the inductor 103 and the duty cycle applied to the boost switch 104 with the Boost PFC controller 105.

This current can then be used jointly with calculated Iinv to determine the HF contents of capacitor current:

$$=> \text{Icap\_HF} = \text{Idc\_HF} - \text{Iinv\_HF} \ (\text{since Idc} = \text{Ic+Iinv})$$

The invention is not limited to the above described examples and in particular the principle of the invention makes the proposed method applicable to several type of power converters including inverters feeding low inductance motor that generate high current ripple, e.g. ripple that cannot be considered constant during a whole switching state.

**Claims**

1.  A method of performing monitoring of parameters of a DC bus capacitor bank (2), composed of at least one capacitor, in a power converter with a front-end (1), an output stage (3) and PWM control (7) of gates of switches of the output stage, said power converter having current sensing means (5, 6) on output phases of the output stage and a voltage sensing means (8, 81) on the DC-bus, said voltage sensing means comprising a conditioning circuit (81) to extract and scale HF ripple of the DC-bus voltage, said method comprising the steps of calculating a HF part of the output stage input current (Iinv) through current measurements sensed by said current sensing means at selected time locations between switching states of the output stage and calculating a HF part of the DC-bus voltage (Vdc) through voltage measurements sensed by said voltage sensing means within selected switching states, wherein the front end is a DC front end providing a DC bus voltage, **characterized in that** said method comprises:

    - determining for a switching cycle (16), sampling locations (11, 12) of phase currents and voltage ripple within different switching states (100, 101, 102, 103) of said cycle where said switching states correspond to particular combinations of gates activation for a switching duration $\Delta T$, and where said sampling locations are located at a first position (21, 24) and a second position (20, 23) within said switching state duration;
    - measuring phase currents of the output stage with said current sensing means (5, 6), sampling the phase currents at said sampling locations for providing phase current values at said locations and calculating the input current Iinv of the output stage based on said phase currents and switching state at said locations;
    - calculating the HF capacitor current at the said sampling locations by using the input current Iinv of the output stage at said locations;
    - reconstructing the HF capacitor current Icap_HF at the beginning of a switching state by linear extrapolation of the HF part of the capacitor current at said locations over said switching state;
    - calculating $\Delta$Icap_HF as the difference of capacitor HF current at the beginning of a new switching state and the value at the end of a previous switching state;
    - measuring the DC bus voltage with the voltage sensing means and conditioning such voltage to extract and scale the HF ripple of the DC bus voltage ripple and sampling said voltage ripple at said sampling locations for providing voltage ripple values in said switching state;
    - reconstructing the HF capacitor voltage through calculating a value of capacitor voltage ripple at the beginning of a switching state by linear extrapolation of the DC bus voltage ripple at said locations over said switching state;
    - calculating $\Delta$Vcap_HF as the difference of HF capacitor voltage ripple at the beginning of a new switching state and the value at the end of a previous switching state;

    and wherein said current ripple and voltage ripple are ripples generated by the standard operation of the power converter without injection of disturbances in the converter.

2. Method as claimed in claim 1 wherein said sampling locations are defined to provide a middle of switching state position as said first position and a near end of switching state position as said second position.

3. Method as claimed in claim 1 or 2 where a parameter under monitoring is the equivalent series resistance ESR of the capacitor bank, the method comprising further calculating an approximated ESR through:

$$ESR = \frac{\Delta Vcap\_HF}{\Delta Icap\_HF}$$

4. Method according to claim 3 comprising estimating an ageing state of said capacitor bank by comparing the calculated ESR value with a limit value.

5. Method according to claim 3 or 4 where a parameter is the capacitance (C) of the capacitor bank, the method comprises further calculating said capacitance through measurements within a first vector followed by a second vector where one of said first and second vector is an active vector and the other of said first and second vector is a null vector and comprising:

- calculating the variation $\Delta Vcap(1)$ of voltage ripple over a duration $\Delta T1$ in said null vector and preceding or following said active vector;
- calculating the variation $\Delta Vcap(2)$ of voltage ripple over a duration $\Delta T2$ in said active vector using DC bus voltage measurements made at a middle of switching state position (t3) and a near end of switching state position (t4) in said active vector and extrapolating the voltage value at the beginning of switching state position (t2) of said active vector;
- calculating I1avg=average HF capacitor current during said active vector;
- calculating

$$\Delta Vc(2) = \Delta Vcap(2) - ESR \cdot (I1(t4) - I1(t2));$$

- calculating an approximated capacitance C as being

$$C = \text{Abs}\left(\frac{I1avg}{\frac{\Delta Vc(1)}{\Delta T1} - \frac{\Delta Vc(2)}{\Delta T2}}\right) \text{ with } \Delta Vc(1) = \Delta Vcap(1).$$

6. Method according to any one of claims 1 to 4 wherein a parameter is the capacitance (C) of the capacitor bank and wherein Iinv is considered constant within a switching state, the method comprising further calculating an approximated capacitance through the formula:

$$C = \frac{I1avg}{\frac{\Delta V'cap(1)}{\Delta T'1} - \frac{\Delta V'cap(2)}{\Delta T'2}}$$

Where $\Delta T'2$ corresponds to a second half period duration of an active vector (131) reduced by the sampling margin and dead time duration and where $\Delta V'cap(1)$ (151) corresponds to the variation of voltage ripple over a duration $\Delta T'1$ in a null vector and preceding or following said active vector, $\Delta V'cap(2)$ (152) corresponds to the difference between the two measured values at an end position (t'4) and at a middle (t'3) position in said active vector, and where I1avg (153) corresponds to the current value of Iinv at the middle position (t'3) of said active vector.

7. Method according to any one of claims 3 to 6 comprising estimating an ageing state of said capacitor bank by comparing, during normal operation of the power converter, the calculated capacitance value and/or the calculated equivalent series resistance value with limit values function of the measured or estimated capacitor temperature.

8. Method according to any one of the preceding claims wherein reconstructing the voltage ripple comprises removing the DC component of said voltage for delivering a ripple containing only the LF+HF contents.

9. Method according to any one of the preceding claims wherein sampling of the phases currents is done in at least one active switching state or active vector where energy is exchanged between the DC bus capacitor and a load of the inverter for providing calculation of HF capacitor current ripple in said active switching state.

10. Method according to any one of the preceding claims wherein the converter being a three-phase inverter system having current sensing means on at least two phases, said current sampling is done on said at least two phases of the inverter.

11. Method according to any one of the preceding claims wherein the front end delivering DC+LF+HF content, the method comprising measurement or calculation of the HF part of the front end current in order to subtract such content from the estimated capacitor current.

12. Method according to any one of claims 1 to 4 wherein, the capacitor current not comprising unknown LF component, the method comprises a measurement of the capacitor voltage variation $\Delta V'cap(2)$ of a duration $\Delta T'2$ within a single active vector switching state, a measurement of the mean output stage current in said switching state and a calculation of C according to the formula:

$$C = Abs(\frac{I1avg}{\frac{\Delta V'cap(2)}{\Delta T'2}})$$

13. Method according to claim 12 wherein estimation of capacitance is obtained by retaining and averaging only the largest C estimations.

14. Monitoring process of a capacitor bank of a power converter with the method of any one of the preceding claims comprising a calibration process and memorization process at the beginning of operation of said power converter for providing and memorizing initial values for the monitoring and calculation of limit values based on said initial values.

15. A power converter system configured to carry out the method of any one of claims 1 to 13 for monitoring of parameters of a DC bus capacitor bank, said power converter system comprising:

  - a front-end feeding power to a DC bus;
  - a capacitor bank;
  - an output stage (3) and PWM control (7) of gates of switches of the output stage, said output stage providing one or more output phases;
  - a voltage sensing means (8, 81) on the DC bus of the capacitor bank, said voltage sensing means comprising a conditioning circuit (81) providing high pass filtering and scaling of a HF component of the DC bus;
  - current sensing means on phases of the output stage of the converter allowing calculation of the output stage input current;
  - a calculation unit (71) such as in a CPU or DSP (7) comprising analog to digital converters and configured to execute, in addition of standard control of the output stage of the converter, calculations of sampling positions, acquisitions of sampled values of voltage and current at said sampling positions and calculation of parameters and limits based on said acquisitions;
  - read only memory and read/write memory for executing said method, read/write permanent memory for storing initial values and limit values and read/write memory for processing calculations.

## Patentansprüche

1. Verfahren zum Durchführen einer Überwachung von Parametern einer DC-Bus-Kondensatorbank (2), welche aus wenigstens einem Kondensator zusammengesetzt ist, in einem Stromwandler mit einem Front-End (1), einer Ausgangsstufe (3) und einer PWM-Steuerung (7) von Gates von Schaltern der Ausgangsstufe, wobei der Stromwandler Stromerfassungsmittel (5, 6) an Ausgangsphasen der Ausgangsstufe und Spannungserfassungsmittel (8, 81) an dem DC-Bus aufweist, wobei die Spannungserfassungsmittel eine Konditionierungsschaltung (81) umfassen, um eine HF-Welligkeit der DC-Bus-Spannung zu extrahieren und zu skalieren, wobei das Verfahren die Schritte eines Berechnens eines HF-Teils des Ausgangsstufe-Eingangsstroms (*Iinv*) durch Strommessungen, welche durch die Stromerfassungsmittel zu ausgewählten Zeitstellen zwischen Schaltzuständen der Ausgangsstufe erfasst werden, und eines Berechnens eines HF-Teils der DC-Bus-Spannung (*Vdc*) durch Spannungsmessungen, welche durch die Spannungserfassungsmittel innerhalb ausgewählter Schaltzustände erfasst werden, umfasst, wobei das Front-End ein DC-Front-End ist, welches eine DC-Bus-Spannung bereitstellt, **dadurch gekennzeichnet, dass** das Verfahren umfasst:

- Bestimmen für einen Schaltzyklus (16) von Abtaststellen (11, 12) von Phasenströmen und einer Spannungswelligkeit innerhalb verschiedener Schaltzustände (100, 101, 102, 103) des Zyklus, wobei die Schaltzustände bestimmten Kombinationen einer Gates-Aktivierung für eine Schaltdauer *ΔT* entsprechen und wobei sich die Abtaststellen an einer ersten Position (21, 24) und einer zweiten Position (20, 23) innerhalb der Schaltzustandsdauer befinden;
- Messen von Phasenströmen der Ausgangsstufe mit den Stromerfassungsmitteln (5, 6), Abtasten der Phasenströme an den Abtaststellen zum Bereitstellen von Phasenstromwerten an den Stellen und Berechnen des Eingangsstroms *Iinv* der Ausgangsstufe auf Grundlage der Phasenströme und des Schaltzustands an den Stellen;
- Berechnen des HF-Kondensatorstroms an den Abtaststellen unter Verwendung des Eingangsstroms *Iinv* der Ausgangsstufe an den Stellen;
- Rekonstruieren des HF-Kondensatorstroms *Icap_HF* zu Beginn eines Schaltzustands durch lineare Extrapolation des HF-Teils des Kondensatorstroms an den Stellen über den Schaltzustand;
- Berechnen von *Icap_HF* als die Differenz des Kondensator-HF-Stroms zu Beginn eines neuen Schaltzustands und des Werts am Ende eines vorherigen Schaltzustands;
- Messen der DC-Bus-Spannung mit den Spannungserfassungsmitteln und Konditionieren einer derartigen Spannung, um die HF-Welligkeit der DC-Bus-Spannungswelligkeit zu extrahieren und zu skalieren, und Abtasten der Spannungswelligkeit an den Abtaststellen zum Bereitstellen von Spannungswelligkeitswerten in dem Schaltzustand;
- Rekonstruieren der HF-Kondensatorspannung durch Berechnen eines Werts einer Kondensatorspannungswelligkeit zu Beginn eines Schaltzustands durch lineare Extrapolation der DC-Bus-Spannungswelligkeit an den Stellen über den Schaltzustand;
- Berechnen von *Icap_HF* als die Differenz einer HF-Kondensatorspannungswelligkeit zu Beginn eines neuen Schaltzustands und des Werts am Ende eines vorherigen Schaltzustands;

und wobei die Stromwelligkeit und die Spannungswelligkeit Welligkeiten sind, welche durch den Standardbetrieb des Stromwandlers ohne ein Einbringen von Störungen in den Wandler erzeugt werden.

2. Verfahren nach Anspruch 1, wobei die Abtaststellen definiert werden, um eine Mitte einer Schaltzustandsposition als die erste Position und ein nahes Ende einer Schaltzustandsposition als die zweite Position bereitzustellen.

3. Verfahren nach Anspruch 1 oder 2, wobei ein Parameter unter Überwachung der äquivalente Serienwiderstand ESR der Kondensatorbank ist, wobei das Verfahren ferner ein Berechnen eines angenäherten ESR umfasst, durch:

$$ESR = \frac{\Delta Vcap\_HF}{\Delta Icap\_HF}$$

4. Verfahren nach Anspruch 3, umfassend ein Schätzen eines Alterungszustands der Kondensatorbank durch ein Vergleichen des berechneten ESR-Werts mit einem Grenzwert.

5. Verfahren nach Anspruch 3 oder 4, wobei ein Parameter die Kapazität (C) der Kondensatorbank ist, wobei das Verfahren ferner ein Berechnen der Kapazität durch Messungen innerhalb eines ersten Vektors gefolgt von einem zweiten Vektor umfasst, wobei einer des ersten und des zweiten Vektors ein aktiver Vektor ist und der andere des ersten und des zweiten Vektors ein Nullvektor ist, und umfassend:

- Berechnen der Variation *ΔVcap*(1) einer Spannungswelligkeit über eine Dauer *ΔT*1 in dem Nullvektor und dem aktiven Vektor vorausgehend oder folgend;
- Berechnen der Variation *ΔVcap*(2) einer Spannungswelligkeit über eine Dauer *ΔT*2 in dem aktiven Vektor unter Verwendung von DC-Bus-Spannungsmessungen, welche in einer Mitte der Schaltzustandsposition (t3) und einem nahen Ende der Schaltzustandsposition (t4) in dem aktiven Vektor vorgenommen werden, und Extrapolieren des Spannungswerts zu Beginn der Schaltzustandsposition (t2) des aktiven Vektors;
- Berechnen des *I1avg = average* HF-Kondensatorstroms während des aktiven Vektors;
- Berechnen von

$$\Delta Vc(2) = \Delta Vcap(2) - ESR \cdot (I1(t4) - I1(t2));$$

- Berechnen einer angenäherten Kapazität C als

$$C = Abs\left(\frac{I1avg}{\frac{\Delta Vc(1)}{\Delta T1} - \frac{\Delta Vc(2)}{\Delta T2}}\right) \text{ mit } \Delta Vc(1) = \Delta Vcap(1).$$

6. Verfahren nach einem der Ansprüche 1 bis 4, wobei ein Parameter die Kapazität (C) der Kondensatorbank ist und wobei *Iinv* innerhalb eines Schaltzustands als konstant angenommen wird, wobei das Verfahren ferner ein Berechnen einer angenäherten Kapazität umfasst, durch die Formel:

$$C = \frac{I1avg}{\frac{\Delta V'cap(1)}{\Delta T'1} - \frac{\Delta V'cap(2)}{\Delta T'2}}$$

wobei $\Delta T'2$ einer zweiten Halbperiodendauer eines aktiven Vektors (131) entspricht, welche durch die Abtastspanne und die Totzeitdauer reduziert wird, und wobei $\Delta V'cap(1)$ (151) der Variation einer Spannungswelligkeit über eine Dauer $\Delta T'1$ in einem Nullvektor und dem aktiven Vektor vorausgehend oder folgend entspricht, $\Delta V'cap(2)$ (152) der Differenz zwischen den zwei gemessenen Werten in einer Endposition (t'4) und in einer mittleren (t'3) Position in dem aktiven Vektor entspricht und wobei *I1avg* (153) dem Stromwert von *Iinv* in der mittleren Position (t'3) des aktiven Vektors entspricht.

7. Verfahren nach einem der Ansprüche 3 bis 6, umfassend ein Schätzen eines Alterungszustands der Kondensatorbank durch ein Vergleichen, während eines normalen Betriebs des Stromwandlers, des berechneten Kapazitätswerts und/oder des berechneten äquivalenten Serienwiderstandswerts mit einer Grenzwertefunktion der gemessenen oder geschätzten Kondensatortemperatur.

8. Verfahren nach einem der vorhergehenden Ansprüche, wobei das Rekonstruieren der Spannungswelligkeit ein Entfernen der DC-Komponente der Spannung zum Liefern einer Welligkeit umfasst, welche nur die LF+HF-Anteile enthält.

9. Verfahren nach einem der vorhergehenden Ansprüche, wobei das Abtasten der Phasenströme in wenigstens einem aktiven Schaltzustand oder aktiven Vektor erfolgt, wobei Energie zwischen dem DC-Bus-Kondensator und einem Verbraucher des Wechselrichters zum Bereitstellen einer Berechnung einer HF-Kondensator-Stromwelligkeit in dem aktiven Schaltzustand ausgetauscht wird.

10. Verfahren nach einem der vorhergehenden Ansprüche, wobei der Wandler ein Dreiphasen-Wechselrichtersystem ist, welches Stromerfassungsmittel an wenigstens zwei Phasen aufweist, wobei das Stromabtasten an den wenigstens zwei Phasen des Wechselrichters erfolgt.

11. Verfahren nach einem der vorhergehenden Ansprüche, wobei das Front-End einen DC+LF+HF-Anteil liefert, wobei das Verfahren eine Messung oder eine Berechnung des HF-Teils des Front-End-Stroms umfasst, um einen derartigen Anteil von dem geschätzten Kondensatorstrom zu subtrahieren.

12. Verfahren nach einem der Ansprüche 1 bis 4, wobei, wenn der Kondensatorstrom keine unbekannte LF-Komponente umfasst, das Verfahren eine Messung der Kondensatorspannungsvariation $\Delta V'cap(2)$ einer Dauer $\Delta T'2$ innerhalb eines Schaltzustands eines einzelnen aktiven Vektors, eine Messung des mittleren Ausgangsstufenstroms in dem Schaltzustand und eine Berechnung von C umfasst, gemäß der Formel:

$$C = Abs\left(\frac{I1avg}{\frac{\Delta V'cap(2)}{\Delta T'2}}\right)$$

13. Verfahren nach Anspruch 12, wobei die Schätzung der Kapazität durch ein Behalten und ein Mitteln nur der größten C-Schätzungen erhalten wird.

14. Überwachungsprozess einer Kondensatorbank eines Stromwandlers mit dem Verfahren nach einem der vorhergehenden Ansprüche, umfassend einen Kalibrierungsprozess und einen Speicherprozess zu Beginn eines Betriebs des Stromwandlers zum Bereitstellen und Speichern von Anfangswerten für die Überwachung und die Berechnung von Grenzwerten auf Grundlage der Anfangswerte.

15. Stromwandlersystem, welches dazu eingerichtet ist, das Verfahren nach einem der Ansprüche 1 bis 13 zum Überwachen von Parametern einer DC-Bus-Kondensatorbank auszuführen, wobei das Stromwandlersystem umfasst:

- Front-End-Einspeiseleistung an einen DC-Bus;
- eine Kondensatorbank;
- eine Ausgangsstufe (3) und eine PWM-Steuerung (7) von Gates von Schaltern der Ausgangsstufe, wobei die Ausgangsstufe eine oder mehrere Ausgangsphasen bereitstellt;
- Spannungserfassungsmittel (8, 81) an dem DC-Bus der Kondensatorbank, wobei die Spannungserfassungsmittel eine Konditionierungsschaltung (81) umfassen, welche eine Hochpassfilterung und eine Skalierung einer HF-Komponente des DC-Bus bereitstellt;
- Stromerfassungsmittel an Phasen der Ausgangsstufe des Wandlers, welche eine Berechnung des Ausgangsstufeneingangsstroms ermöglichen;
- eine Berechnungseinheit (71), beispielsweise in einer CPU oder einem DSP (7), welche Analog-zu-Digital-Wandler umfasst und dazu eingerichtet ist, zusätzlich zu einer Standardsteuerung der Ausgangsstufe des Wandlers, Berechnungen von Abtaststellen, Erfassungen abgetasteter Werte von Spannung und Strom an den Abtaststellen und eine Berechnung von Parametern und Grenzen auf Grundlage der Erfassungen auszuführen;
- einen Nur-Lese-Speicher und einen Lese-Schreib-Speicher zum Ausführen des Verfahrens, einen permanenten Lese-Schreib-Speicher zum Speichern von Anfangswerten und Grenzwerten und einen Lese-Schreib-Speicher zum Verarbeiten von Berechnungen.

## Revendications

1. Procédé de mise en œuvre de la surveillance de paramètres d'une batterie de condensateurs de bus CC (2), composée d'au moins un condensateur, dans un convertisseur de puissance ayant une extrémité frontale (1), un étage de sortie (3) et une commande (7) de modulation d'impulsions en durée (MID) de portes de commutateurs de l'étage de sortie, ledit convertisseur de puissance ayant un moyen de détection de courant (5, 6) sur des phases de sortie de l'étage de sortie et un moyen de détection de tension (8, 81) sur le bus CC, ledit moyen de détection de tension comprenant un circuit de conditionnement (81) pour extraire et mettre à l'échelle l'ondulation haute fréquence (HF) de la tension de bus CC, ledit procédé comprenant les étapes consistant à calculer une partie HF du courant d'entrée (Iinv) de l'étage de sortie par des mesures de courant détectées par ledit moyen de détection de courant à des emplacements temporels sélectionnés entre des états de commutation de l'étage de sortie et à calculer une partie HF de la tension (Vdc) de bus CC par des mesures de tension détectées par ledit moyen de détection de tension dans des états de commutation sélectionnés, dans lequel l'extrémité frontale est une extrémité frontale CC fournissant une tension de bus CC, **caractérisé en ce que** ledit procédé comprend :

- la détermination pour un cycle de commutation (16), d'emplacements d'échantillonnage (11, 12) de courants de phase et d'ondulation de tension dans différents états de commutation (100, 101, 102, 103) dudit cycle où lesdits états de commutation correspondent à des combinaisons particulières d'activation de portes pendant une durée de commutation ΔT, et où lesdits emplacements d'échantillonnage sont situés à une première position (21, 24) et à une seconde position (20, 23) dans ladite durée d'état de commutation ;
- la mesure de courants de phase de l'étage de sortie avec ledit moyen de détection de courant (5, 6), l'échantillonnage des courants de phase auxdits emplacements d'échantillonnage pour fournir des valeurs de courant de phase au niveau desdits emplacements et le calcul du courant d'entrée Iinv de l'étage de sortie sur la base desdits courants de phase et de l'état de commutation au niveau desdits emplacements ;

- le calcul du courant de condensateur HF auxdits emplacements d'échantillonnage en utilisant le courant d'entrée Iinv de l'étage de sortie au niveau desdits emplacements ;
- la reconstruction du courant Icap_HF de condensateur HF au début d'un état de commutation par l'extrapolation linéaire de la partie HF du courant de condensateur au niveau desdits emplacements pendant ledit état de commutation ;
- le calcul de ΔIcap_HF sous la forme de la différence du courant HF de condensateur au début d'un nouvel état de commutation et de la valeur à la fin d'un état de commutation précédent ;
- la mesure de la tension de bus CC avec le moyen de détection de tension et le conditionnement de cette tension pour extraire et mettre à l'échelle l'ondulation HF de l'ondulation de tension de bus CC et l'échantillonnage de ladite ondulation de tension au niveau desdits emplacements d'échantillonnage pour fournir des valeurs d'ondulation de tension dans ledit état de commutation ;
- la reconstruction de la tension de condensateur HF par le calcul d'une valeur d'ondulation de tension de condensateur au début d'un état de commutation par l'extrapolation linéaire de l'ondulation de tension de bus CC au niveau desdits emplacements pendant ledit état de commutation ;
- le calcul de ΔVcap_HF sous la forme de la différence de l'ondulation de tension de condensateur HF au début d'un nouvel état de commutation et de la valeur à la fin d'un état de commutation précédent ;

et dans lequel ladite ondulation de courant et ladite ondulation de tension sont des ondulations générées par le fonctionnement standard du convertisseur de puissance sans injection de perturbations dans le convertisseur.

2. Procédé selon la revendication 1 dans lequel lesdits emplacements d'échantillonnage sont définis pour fournir une position médiane d'état de commutation en tant que ladite première position et une position d'extrémité proche d'état de commutation en tant que ladite seconde position.

3. Procédé selon la revendication 1 ou 2 où un paramètre sous surveillance est la résistance-série équivalente ESR de la batterie de condensateurs, le procédé comprenant en outre le calcul d'une ESR approchée par :

$$ESR = \frac{\Delta Vcap\_HF}{\Delta Icap\_HF}$$

4. Procédé selon la revendication 3 comprenant l'estimation d'un état de vieillissement de ladite batterie de condensateurs en comparant la valeur d'ESR calculée à une valeur limite.

5. Procédé selon la revendication 3 ou 4 où un paramètre est la capacité (C) de la batterie de condensateurs, le procédé comprend en outre le calcul de ladite capacité par des mesures dans un premier vecteur suivi d'un second vecteur où l'un desdits premier et second vecteurs est un vecteur actif et l'autre desdits premier et second vecteurs est un vecteur nul et comprenant :

- le calcul de la variation ΔVcap (1) de l'ondulation de tension sur une durée ΔT1 dans ledit vecteur nul et précédant ou suivant ledit vecteur actif ;
- le calcul de la variation ΔVcap (2) de l'ondulation de tension sur une durée ΔT2 dans ledit vecteur actif en utilisant des mesures de tension de bus CC effectuées à une position médiane (t3) d'état de commutation et une position d'extrémité proche (t4) d'état de commutation dans ledit vecteur actif et l'extrapolation de la valeur de tension à la position de début (t2) d'état de commutation dudit vecteur actif ;
- le calcul de I1avg = courant moyen de condensateur HF pendant ledit vecteur actif ;
- le calcul de ΔVc(2) = ΔVcap(2) - ESR · (I1(t4) - II(t2)) ;
- le calcul d'une capacité C approchée comme étant

$$C = Abs\left(\frac{I1avg}{\frac{\Delta Vc(1)}{\Delta T1} - \frac{\Delta Vc(2)}{\Delta T2}}\right) \quad \text{avec } \Delta Vc(1) = \Delta Vcap(1).$$

6. Procédé selon l'une quelconque des revendications 1 à 4 dans lequel un paramètre est la capacité (C) de la batterie de condensateurs et dans lequel Iinv est considéré comme constant dans un état de commutation, le procédé comprenant en outre le calcul d'une capacité approchée par la formule :

$$C = \frac{I1avg}{\dfrac{\Delta V'cap(1)}{\Delta T'1} - \dfrac{\Delta V'cap(2)}{\Delta T'2}}$$

où $\Delta T'2$ correspond à une seconde durée de demi-période d'un vecteur actif (131) réduite par la marge d'échantillonnage et la durée de temps mort et où $\Delta V'cap(1)$ (151) correspond à la variation d'ondulation de tension sur une durée $\Delta T'1$ dans un vecteur nul et précédant ou suivant ledit vecteur actif, $\Delta V'cap(2)$ (152) correspond à la différence entre les deux valeurs mesurées à une position d'extrémité (t'4) et à une position médiane (t'3) dans ledit vecteur actif, et où I1avg (153) correspond à la valeur de courant de Iinv à la position médiane (t'3) dudit vecteur actif.

7. Procédé selon l'une quelconque des revendications 3 à 6 comprenant l'estimation d'un état de vieillissement de ladite batterie de condensateurs en comparant, pendant le fonctionnement normal du convertisseur de puissance, la valeur de capacité calculée et/ou la valeur de résistance-série équivalente calculée à des valeurs limites en fonction de la température mesurée ou estimée du condensateur.

8. Procédé selon l'une quelconque des revendications précédentes dans lequel la reconstruction de l'ondulation de tension comprend la suppression de la composante CC de ladite tension pour délivrer une ondulation contenant uniquement les contenus LF + HF.

9. Procédé selon l'une quelconque des revendications précédentes dans lequel l'échantillonnage des courants de phases est effectué dans au moins un état actif de commutation ou un vecteur actif où de l'énergie est échangée entre le condensateur de bus CC et une charge de l'inverseur pour fournir le calcul de l'ondulation de courant de condensateur HF dans ledit état actif de commutation.

10. Procédé selon l'une quelconque des revendications précédentes dans lequel le convertisseur étant un système inverseur triphasé ayant un moyen de détection de courant sur au moins deux phases, ledit échantillonnage de courant est effectué sur lesdites au moins deux phases de l'inverseur.

11. Procédé selon l'une quelconque des revendications précédentes dans lequel l'extrémité frontale délivrant un contenu CC + LF + HF, le procédé comprenant la mesure ou le calcul de la partie HF du courant d'extrémité frontale afin de soustraire ce contenu du courant de condensateur estimé.

12. Procédé selon l'une quelconque des revendications 1 à 4 dans lequel, le courant de condensateur ne comprenant pas de composante LF inconnue, le procédé comprend une mesure de la variation $\Delta V'cap(2)$ de tension de condensateur d'une durée $\Delta T'2$ dans un seul état de commutation de vecteur actif, une mesure du courant moyen d'étage de sortie dans ledit état de commutation et un calcul de C selon la formule :

$$C = Abs\left(\frac{I1avg}{\dfrac{\Delta V'cap(2)}{\Delta T'2}}\right)$$

13. Procédé selon la revendication 12 dans lequel l'estimation de la capacité est obtenue en conservant et en faisant la moyenne uniquement des estimations de C les plus grandes.

14. Procédé de surveillance d'une batterie de condensateurs d'un convertisseur de puissance avec le procédé selon l'une quelconque des revendications précédentes comprenant un procédé d'étalonnage et un procédé de mémorisation au début du fonctionnement dudit convertisseur de puissance pour fournir et mémoriser des valeurs initiales pour la surveillance et le calcul de valeurs limites sur la base desdites valeurs initiales.

15. Système de convertisseur de puissance configuré pour mettre en œuvre le procédé selon l'une quelconque des revendications 1 à 13 pour la surveillance de paramètres d'une batterie de condensateurs de bus CC, ledit système de convertisseur de puissance comprenant :

- une extrémité frontale alimentant en énergie un bus CC ;

- une batterie de condensateurs ;
- un étage de sortie (3) et une commande MID (7) de portes de commutateurs de l'étage de sortie, ledit étage de sortie fournissant une ou plusieurs phases de sortie ;
- un moyen de détection de tension (8, 81) sur le bus CC de la batterie de condensateurs, ledit moyen de détection de tension comprenant un circuit de conditionnement (81) fournissant un filtrage passe-haut et une mise à l'échelle d'une composante HF du bus CC ;
- un moyen de détection de courant sur les phases de l'étage de sortie du convertisseur permettant le calcul du courant d'entrée de l'étage de sortie ;
- une unité de calcul (71) telle que dans une unité centrale de traitement ou un processeur de signal numérique (7) comprenant des convertisseurs analogique-numérique et configurée pour exécuter, en plus de la commande standard de l'étage de sortie du convertisseur, des calculs de positions d'échantillonnage, des acquisitions de valeurs échantillonnées de tension et de courant au niveau desdites positions d'échantillonnage et le calcul de paramètres et de limites sur la base desdites acquisitions ;
- une mémoire morte et une mémoire vive pour l'exécution dudit procédé, une mémoire vive permanente pour le stockage des valeurs initiales et des valeurs limites et une mémoire vive pour le traitement des calculs.

## Fig. 1

## Fig. 7

Fig. 2

**Fig. 3**

EP 3 715 879 B1

Fig. 4B

Fig. 4A

**Fig. 5**

Switching info

Calculated =f(switching info, sampled phases currents)

Calculated capacitor current (-Iinv)

extrapolated

calculated

Voltage ripple (LF + HF)

Dead time duration

measured

extrapolated

measured

$\Delta T1$  $\Delta T2$

Sampling margin  Sampling margin

D2

130  131  161

143

142

141

t0  t1 t2  t3  t4

time

EP 3 715 879 B1

Fig. 6

132    133    161

D1    D2

Sampling margin    Sampling margin    Switching info

153

Calculated =f(switching info, sampled phases currents)    Calculated capacitor current (-Iinv)

0

151

Dead time duration

measured

Voltage ripple (LF + HF)

ΔT'1    ΔT'2    152    time

t'0    t'1    t'2    t'3    t'4

EP 3 715 879 B1

26

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009072839 A1
- US 2005169018 A